# EUROPEAN PATENT SPECIFICATION

(11) **EP 1 521 093 B1**
(45) Date of publication and mention of the grant of the patent: **11.01.2006**
(21) Application number: 03021995.0
(22) Date of filing: 30.09.2003
(51) Int. Cl.: G01R 31/3183, G01R 31/317, G06F 17/50

(54) **Long running test method for a circuit design analysis**
Verfahren zur langlaufenden Analyse eines Schaltkreisentwurfs
Procédé de test de longue durée pour l'analyse de la conception d'un circuit

(43) Date of publication of application: 06.04.2005
(73) Proprietor: Infineon Technologies AG, 81669 München (DE)
(72) Inventor: Liau, Chee Hong Eric, 80339 München (DE)
(74) Representative: Hudler, Frank

(56) References cited:
- US-A- 6 098 186
- US-A- 6 115 835
- US-B1- 6 347 386

## Description

The invention concerns a long running test method to mimic real-device application testing for circuit design analysis and circuit simulation to detect and analyse potential design failure related to application faults such as functional, current, voltages using ATE (Automatic Test Equipment).

Typical test pattern analysis via ATE or circuit simulation is very difficult to detect potential design weakness or abnormal behavior in real customer application faults. There are a lot of cases that customers have a problem to run the chip while even through the chip passed all tests in the producers analysis lab.

Therefore the major technical problem and challenge is how to perform a test or develop a technique which can cover or at least close to the test in real customer application via ATE or a complete circuit simulation based on the real customer application, but without using the real customer application setup e.g. the hardware and the software.

In case there are known customer failures it is hardly to get any useful information to start an analysis. The application test only indicates that the chip runs or not under what test conditions. Thus, it usually depend on individual design analysis experiences, trial and error, plus a lot of time consuming discussions until the problem have been solved.

There exist a lot of practical technical problems to be solved by application fault analysis via conventional way.

It is very difficult to localize the design weakness or faults due to application failures using circuit simulation depend on a small set of pre-defined trial error simulation pattern.

Very large random customer like pattern is not practical for circuit simulation analysis. Further more typical run time of ATE test patterns is not practical for circuit simulation analysis.

The typical run time of ATE test patterns are short, that means less than a "sec" or "minutes". Therefore the test can only represent a part of functionally verification, but it does not imply that the same test can survive in real application for much longer time, such as "a same timely test sequence have been repeatedly executed" for more than a few "hours" instead of "sec" or "minutes".

The question is that can the chip hang up after a few hours or how robust is the design. This behavior is not possible to be seen by the conventional way of testing.

Another problem is that typical application test approach requires to set up all customer like hardware in order to produce and study the behavior of the chip in real application. But this test or analysis approach can not actually show when the chip fails and how the chip fails.

The US 6 098 186 describes a test permutator. This method is selecting of permutations of a plurality of parameters, which is input test signal combination. This can be a group of single bit or just a single signal. The major challenge of this method is to solve the very large combination of input test signal combination. The permutation sequence according according to this method provides a excellent compromise between coverage and require time, since all compromise between coverage and require time, since all parameters are varied concurrently. But this method can not guarantee the coverage of all combination including those potential worst case, critical or application failure related sequence. This is because the test permutator is opnly selecting of test with dedicated permutation based on the probability of each parameter variation.

From the US 6 347 386 B1 is known a system for optimizing the testing and repair time of a defective integrated circuit. This method is designed to reduce the time to repair those reparable defective memory devices. The major idea of this system is to have a test identifier to identify which chip failed with what test and then extract them to re-test to confirm the failure, finally repair it if.this chip is reparable.

The invention of US 6 347 386 B1 is tried to log a test identifier for all those pre-selected and defined tests using ATE test system, all tests are pre-loaded. Different chip could fail with any different pre-defined tests. Therefore it is difficult to sort them latter. The failure chip together with the failure test identifier is logged into a database but not the whole test sequence or test content or specific failure time. Thus it is not common to log such a test sequence or test content or specific failure time at all, one of the major reason is that because all of their test are known and well-defined before pre-loaded into ATE.

The robustness of a chip was not tested (only functional testing) before shifting the engineering sample to the customer.

Therefore it is an object of the invention to prevent the disadvantage of the prior art to provide an analysis technique to localize the design weakness or defaults due to Another object of the invention is to provide an analysis technique which actually shows when the chip fails and how it fails.

Another object of the invention is to provide an analysis technique for a much longer test sequence.

The problems are solved by the features mentioned in claim one. Further embodiments are claimed in the accompanying sub claims.

Before starting the test can apply a pre-check of robust pattern to the device under test and recording the output of the test results (pass or fail) under the same test condition into LRT database.

The long running test is started with pre-defined long running test conditions which are run time and run time per test.

After the LRT test can applied a post-check of robust check pattern to the device under test. The output of the test results (pass or fail) under the same test conditions are recorded into final database.

The design defective or weakness due to application failures is identified by a small set of test pattern, test condition, LRT failure time and robustness check.

The design defective and weakness based on LRT failure time and test sequence is finally localized by circuit simulation.

The invention solves all technical problems mentioned in the prior art description by a long running test (LRT) concept. The main concept of the LRT imitate the application test behavior and condition. All dedicated test conditions and test pattern are executing or generating continuously for a time given by a user.

The running time can be a few hours, days or a few minutes, seconds etc. The testing time is similar to the application test so that if any application fault occurs, the test will automatically stop and log the failure time and timely test sequence.

Then another test is started again until the maximum number of LRT is reached. The number of LRT test is also given by the user. Because all tests are running for some time and mostly long time like application test the new design analysis technique is called as a long running test.

It is integrated such a similar application idea into ATE to detect a small set of timely test sequence and test conditions cause potential application failures, and then this set of test pattern and test conditions are further analyzed by circuit simulation.

Such a scheme can efficiently identify a defective and weakness due to application failure as well as locate the defect or weakness within design in a much shorter time compares to typical way according the prior art. This is the major advantage of the invention, while conventional way of testing can not handle such a problem systematically and efficiently.

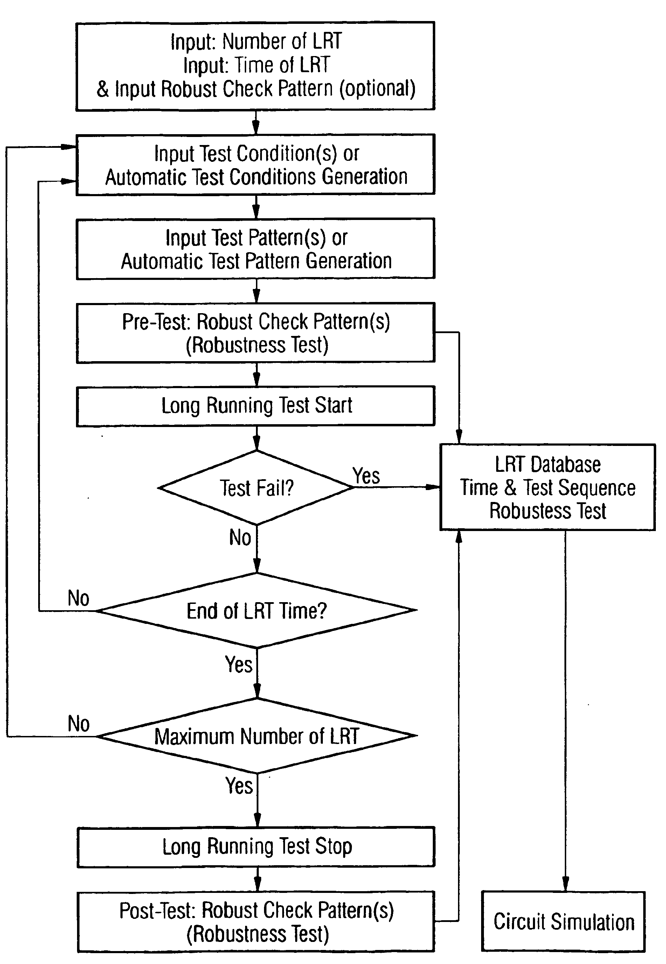

The invention is described with an example now. The accompanying drawing shows a schematic diagram with the several steps of the LRT technique for robust and application analysis.

Referring now to the drawing is defined first the LRT run time, the LRT loops, the test condition generation and the test pattern generation. After that generation of test stimuli (test pattern) and test conditions via the automatic test equipment (ATE) based or any other measurement system.

In the next step the test stimuli and test conditions are applied to a device under test (DUT).

Optional applying a pre-check of robust check pattern to the device under test (DUT) and record the output of the test results (pass or fail) under the same test conditions into a LRT database.

After that start the long running test (LRT) with the pre-defined condition (i.e. number of LRT run time and run time per test) and monitoring if long running test sequence fail. Record the time and test sequence when the test fail into the LRT database.

Monitoring if end of LRT time the ATE pattern generator is shut down (ATE may hang up if running continuously without proper control procedures) when end of LRT time, otherwise the foregoing steps are repeated until the end of LRT time and end of LRT loop. The LRT is stopped if end of LRT time and end of LRT loop.

After end of LRT can optional applied a post-check of robust check pattern to the device under test (DUT) and record the output of test results (pass or fail) under the same test conditions into final database.

From LRT database, if pre and post check works even if LRT failed, means design does not hang up, if pre-check pass and post-check fail because of LRT fail means it is a very high possibility that the chip is hang up after long running test. That means that the chip may break down some time in real application.

Finally, a small set of test pattern (worst case timely test sequence with respect to LRT failure), test condition, LRT failure time and robustness check, are used to identify the design defective or weakness due to application failures.

At least, circuit simulation analysis based on the foregoing information to localize the design defective and weakness including wafer probing internal signal with respect to worst case test pattern and condition.

### Example:

The experimental results demonstrate that the invention is proved to be much more efficiency to detect potential application failure compares to conventional way of testing. The general concept of the invention as shown in the accompanying drawing can be implemented into any ATE or measurement system.

In order to imitate an application test the test conditions are defined with customer requirement to screen out the first design engineering sample (ES).

Such test conditions are a three core of power supply. E.g. 1, 7 V (low), 1,8 V (norm) and 1,95 V (high), TRC (device row cycle time) is 70 nsec, test pattern with refresh logic turn on and off and each LRT with dedicated power supply level run continuously for 3 hours.

The tested chip hang on less than 30 sec at low power supply level of 1,7 V with refresh on, it is provided by post test robust pattern failed at all data output bus are actually stuck at some values while other command signals hang up at some states. The chip does not hang up at low power supply level of 1, 7 V with refresh off.

The internal signals probing on wafer using a small set of worst case pattern and condition from the invention. There was localized some of the important signal closed to one of the access state machine. All of this information is then converted into circuit simulation. The result of the circuit simulation is that the major root cause for hang up is because one of the access signal collides with possible refresh signal, thus the state machine could not decide which action perform.

Now if done a little calculation of how generate a 40 sec pattern (random or any) using application spec TRC 70 nsec (means every vector is 70 nsec) to capture such a fault. It is immediately realized that the size of the test pattern is not possible to achieve, or none of the pattern generator can handle such a big pattern. It could take a few days to generate only one single pattern. Moreover, 30 sec is just one of the value for a design or chip, may be some other test or chip fail after 1 hour or 2 hours etc. Therefore LRT is so important in this particular analysis phase.

## Claims

1. Long running test method to imitate real-device application testing i.e. device under test (DUT) by comprising a simulation procedure stored in a long running test LRT database for circuit design analysis and circuit simulation to detect and analyse potential design weakness or abnormal behaviour related to any application faults using Automatic Test Equipment (ATE), **characterized by** defining test conditions and generating a test with dedicated test conditions and test pattern or pre-defined test for a longer time given by a user like application test using on ATE test pattern and test condition generator, applying all dedicated test conditions and test pattern to the device under test (DUT), stop the long running test (LRT) automatically if either end of LRT time and end of LRT loop or any LRT test sequence failed identifying a defective and weakness due to application failure, and log the timely test sequence and failure time and then start another long running test (LRT) again until the end of number of long running test (LRT).

2. Method for design analysis according claim 1 **characterized by** applying a pre-check of robustness check pattern to the device under test (DUT) and recording the output of the test results -pass or fail- under the same test condition into the long running test LRT database.

3. Method for design analysis according claim 1 **characterized by** starting the long running test with pre-defined long running test (LRT) conditions.

4. Method for design analysis according claim 3 **characterized in that** the predefined long running test (LRT) conditions are the number of long running test (LRT) and running time of the test sequence per test.

5. Method for design analysis according one of the claims 1 to 4 **characterized by** applying a post-check of robustness check pattern to the device under test (DUT) and record the output of the test results -pass or fail- under the same test condition into final database.

6. Method for design analysis according one of the claims 1 to 5 **characterized by** identifying the design defects or weaknesses due to application failures by a small set of test pattern, test condition, long running test (LRT) failure time and robustness check.

7. Method for design analysis technique according claim 6 **characterized by** localizing the design defects or weaknesses based on long running test (LRT) failure time and test sequence by circuit simulation.

## Patentansprüche

1. Langlaufprüfverfahren zur Imitation der Realeinrichtungs-Anwendungsprüfung, d.h. der zu prüfenden Einrichtung (DUT) mit einer in einer Langlaufprüf-LRT-Datenbank gespeicherten Simulationsprozedur zur Schaltungsentwurfsanalyse und Schaltungssimulation zur Erkennung und Analyse potentieller Entwurfsschwächen oder eines abnormen Verhaltens in bezug auf beliebige Anwendungsfehler unter Verwendung automatischer Prüfgeräte (ATE), **gekennzeichnet durch** Definieren von Prüfbedingungen und Erzeugen einer Prüfung mit speziellen Prüfbedingungen und Prüfmustern oder einer vordefinierten Prüfung für eine längere zeit, gegeben **durch** eine benutzerartige Anwendungsprüfung unter Verwendung eines ATE-Prüfmusters und Prüfbedingungsgenerators, Anwenden aller speziellen Prüfbedingungen und Prüfmuster auf die zu prüfende Einrichtung (DUT), automatisches Stoppen der Langlaufprüfung (LRT) entweder am Ende der LRT-Zeit oder dem Ende der LRT-Schleife oder beim Ausfall einer beliebigen LRT-Prüfsequenz, wodurch ein Defekt oder eine Schwäche aufgrund von Anwendungsausfall identifiziert wird, und Protokollieren der zeitlichen Prüfsequenz und Ausfallzeit und dann Starten einer weiteren Langlaufprüfung (LRT) nochmals bis zum Ende einer Zahl der Langlaufprüfung (LRT).

2. Verfahren zur Entwurfsanalyse nach Anspruch 1, **gekennzeichnet durch** Anwenden eines Vorchecks eines Robustheitscheckmusters auf die zu prüfende Einrichtung (DUT) und Verzeichnen der Ausgabe der Prüfergebnisse, bestanden oder durchgefallen, unter derselben Prüfbedingung in der Datenbank der Langlaufprüfung LRT.

3. Verfahren zur Entwurfsanalyse nach Anspruch 1, **gekennzeichnet durch** Starten der Langlaufprüfung mit vordefinierten Bedingungen der Langlaufprüfung (LRT).

4. Verfahren zur Entwurfsanalyse nach Anspruch 3, **dadurch gekennzeichnet, daß** die vordefinierten Bedingungen der Langlaufprüfung (LRT) die Zahl der Langlaufprüfung (LRT) und die Laufzeit der Prüfsequenz pro Prüfung sind.

5. Verfahren zur Entwurfsanalyse nach einem der Ansprüche 1 bis 4, **gekennzeichnet durch** Anwenden eines Nachchecks oder Robustheitscheckmusters auf die zu prüfende Einrichtung (DUT) und Verzeichnen der Ausgabe der Prüfergebnisse, bestanden oder durchgefallen, unter derselben Prüfbedingung in einer Enddatenbank.

6. Verfahren zur Entwurfsanalyse nach einem der Ansprüche 1 bis 5, **gekennzeichnet durch** Identifizieren der Entwurfsdefekte oder -schwächen aufgrund von Anwendungsausfällen **durch** eine kleine Menge von Prüfmustern, Prüfbedingung, Ausfallzeit und Robustheitscheck der Langlaufprüfung (LRT).

7. Verfahren einer Entwurfsanalysetechnik nach Anspruch 6, **gekennzeichnet durch** Lokalisieren der Entwurfsdefekte oder -schwächen auf der Basis der Ausfallzeit und Prüfsequenz der Langlaufprüfung (LRT) durch Schaltungssimulation.

## Revendications

1. Procédé de test de longue durée pour imiter un test d'application réelle d'un dispositif, autrement dit un dispositif sous test (DUT), comprenant une procédure de simulation stockée dans une base de données de tests de longue durée (LRT) pour l'analyse de la conception d'un circuit et la simulation d'un circuit afin de détecter et d'analyser une éventuelle faiblesse de conception ou un éventuel comportement anormal liés à une défaillance quelconque de l'application à l'aide d'un matériel de test automatique (ATE), **caractérisé par** la définition de conditions de test et la génération d'un test avec des conditions de test et un motif de test spécifiques ou d'un test prédéfini pour une durée plus longue donnée par un utilisateur comme un test d'application à l'aide d'un générateur de motifs de test et de conditions de test sur l'ATE, l'application de toutes les conditions de test et du motif de test spécifiques au dispositif sous test (DUT), l'interruption automatique du test de longue durée (LRT) si la fin de la durée LRT et la fin de la boucle LRT ou bien une séquence de test LRT quelconque n'ont ou n'a pas donné lieu à l'identification d'un défaut et d'une faiblesse du fait de l'échec de l'application, et l'enregistrement de la séquence de test en question et de l'instant de l'échec puis le lancement d'un autre test de longue durée (LRT) jusqu'à la fin d'un certain nombre de tests de longue durée (LRT).

2. Procédé d'analyse de la conception selon la revendication 1, **caractérisé par** l'application d'un pré-contrôle de motif de contrôle de robustesse au dispositif sous test (DUT) et l'enregistrement dans la base de données de tests de longue durée (LRT) de la sortie des résultats du test - succès ou échec - dans la même condition de test.

3. Procédé d'analyse de la conception selon la revendication 1, **caractérisé par** le lancement du test de longue durée dans des conditions de test de longue durée (LRT) prédéfinies.

4. Procédé d'analyse de la conception selon la revendication 3, **caractérisé en ce que** les conditions de test de longue durée (LRT) prédéfinies représentent le nombre de tests de longue durée (LRT) et la durée d'exécution de la séquence de test pour chaque test.

5. Procédé d'analyse de la conception selon l'une quelconque des revendications 1 à 4, **caractérisé par** l'application d'un post-contrôle de motif de contrôle de robustesse au dispositif sous test (DUT) et l'enregistrement dans une base de données finale de la sortie des résultats du test - succès ou échec - dans la même condition de test.

6. Procédé d'analyse de la conception selon l'une quelconque des revendications 1 à 5, **caractérisé par** l'identification des défauts ou des faiblesses de conception du fait d'échecs de l'application par un petit groupe comprenant le motif de test, la condition de test, l'instant d'échec de test de longue durée (LRT) et le contrôle de robustesse.

7. Procédé d'analyse de la conception selon la revendication 6, **caractérisé par** la localisation des défauts ou des faiblesses de conception en fonction de l'instant d'échec de test de longue durée (LRT) et de la séquence de test par simulation du circuit.
